# EUROPEAN PATENT APPLICATION

(11) **EP 4 303 908 A1**
(43) Date of publication of application: **10.01.2024**
(21) Application number: 22183148.0
(22) Date of filing: 05.07.2022
(51) Int. Cl.: H01J 37/21

(54) **ASSESSMENT APPARATUS USING A PLURALITY OF CHARGED PARTICLE BEAMS**

(71) Applicant: ASML Netherlands B.V., 5500 AH Veldhoven (NL)
(72) Inventor: HAARTSEN, Thomas Izaak Fred, 5500 AH Veldhoven (NL); BOSCH, Niels, Johannes, Maria, 5500 AH Veldhoven (NL); GRASMAN, Jasper, Hendrik, 5500 AH Veldhoven (NL); SMEETS, Martin, Frans, Pierre, 5500 AH Veldhoven (NL); SLOT, Erwin, 5500 AH Veldhoven (NL); PRIL, Wouter, Onno, 5500 AH Veldhoven (NL); HEMPENIUS, Peter, Paul, San Jose, 95134 (US)
(74) Representative: ASML Netherlands B.V.

(57) **Abstract**

The present disclosure relates to apparatus and methods for assessing samples using a plurality of charged particle beams. In one arrangement, at least a subset of a beam grid of a plurality of charged particle beams and respective target portions of a sample surface are scanned relative to each other to process the target portions. Signal charged particles from the sample are detected to generate detection signals. A sample surface topographical map is generated that represents a topography of the sample surface by analyzing the detection signals.

## Description

### FIELD

The present disclosure relates to apparatus and methods for assessing samples using a plurality of charged particle beams.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment for example inspection and/or measurement of a surface of a substrate, or other object/material, is an important process during and/or after its manufacture.

Assessment tools, which herein are referred to as assessment systems, are known that use a charged particle beam to assess objects, which may be referred to as samples, for example to detect pattern defects. These systems typically use electron microscopy techniques, such as a scanning electron microscope (SEM). In a SEM, a primary electron beam of electrons at a relatively high energy is targeted with a final deceleration step to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection system may obtain an image representing characteristics of the material structure of the surface of the sample.

Higher throughput in assessment systems can be achieved by increasing the number of beams that are simultaneously incident on the sample. Assessment systems configured to operate in this way may be referred to as multi-beam systems and can simultaneously project very large numbers of individual beams onto the sample in parallel over a relatively large area on the sample surface, which may be referred to as the Field of View (FoV). Having a large FoV enables high throughput. It has proven challenging, however, to focus beams accurately over such large FoVs.

### SUMMARY

It is an object of the present disclosure to provide methods and apparatus that support improved control of focus in arrangements that assess samples using pluralities of charged particle beams.

According to an aspect of the invention, there is provided an assessment apparatus for assessing a sample using a plurality of charged particle beams, comprising: a sample support configured to support a sample, the sample having a sample surface; a charged particle device configured to project a beam grid of a plurality of charged particle beams along a grid path of the beam grid towards the sample; a detector configured to detect signal charged particles from the sample and generate detection signals on detection of the signal charged particles; and a control system configured to: control the sample support, the charged particle device and/or the detector to: scan at least a subset of the beam grid and respective target portions of the sample surface relative to each other, so as to process the target portions; and generate a sample surface topographical map representing a topography of the sample surface by analyzing detection signals detected in response to the scan of the at least a subset of the beam grid and respective target portions relative to each other.

According to an aspect of the invention, there is provided an assessment apparatus for assessing a sample using a plurality of charged particle beams, comprising: a sample support configured to support the sample, the sample having a sample surface; a charged particle device configured to project a beam grid of a plurality of charged particle beams along a grid path of the beam grid towards the sample; a plurality of proximity sensors configured to face the sample, each proximity sensor configured to measure a distance between the proximity sensor and the sample and provide output data; and a control system configured to: import an externally-derived topographical map representing a topography of the sample surface measured using an external device; and process the sample using the beam grid while controlling a positioning of the sample using the externally-derived topographical map and the output data from the plurality of proximity sensors.

According to an aspect of the invention, there is provided an assessment apparatus for assessing a sample using a plurality of charged particle beams, comprising: a sample support configured to support a sample, the sample having a sample surface; a charged particle device configured to project a beam grid of a plurality of charged particle beams along a grid path of the beam grid towards the sample; a plurality of proximity sensors configured to face the sample, each proximity sensor configured to measure a distance between the proximity sensor and the sample and provide output data; and a control system configured to: receive a sample support topographical map representing a topography of a surface of the sample support; and process the sample using the beam grid while controlling a positioning of the sample using the sample support topographical map and the output data from the plurality of proximity sensors.

According to an aspect of the invention, there is provided an assessment apparatus for assessing a sample using a plurality of charged particle beams, comprising: a sample support configured to support a sample, the sample having a sample surface; a charged particle device configured to project a beam grid of a plurality of charged particle beams along a grid path of the beam grid towards the sample; an optical measurement system configured to measure a topographical map representing a topography of the sample surface; and a control system configured to use the measured topographical map to control a positioning of the sample during processing of the sample by the beam grid, desirably the optical measurement system comprising a light source and an array of sensing elements, desirably arranged in a linear array desirably dimensioned to extend across a maximum dimension of the sample desirably in a sensing direction, desirably the light source and array of sensing elements configured relative to the sample support such that when the sample is moved relative to the linear array in a scanning direction, desirably angled relative to the sensing direction, desirably the optical measurement system processes the sample surface, desirably the entire sample surface, and the apparatus desirably further comprises a detector configured to detect signal charged particles from the sample and provide an output.

According to an aspect of the invention, there is provided an assessment apparatus for assessing a sample using a plurality of charged particle beams, comprising: a sample support configured to support a sample, the sample having a sample surface; a charged particle device configured to project a beam grid of a plurality of charged particle beams along a grid path of the beam grid towards the sample; a plurality of proximity sensors configured to face the sample, each proximity sensor configured to measure a distance between the proximity sensor and the sample and provide output data; and a control system configured to: generate a sample surface topographical map representing a topography of the sample surface by controlling the sample support to move the sample through a range of positions and/or orientations relative to the charged particle device while using the proximity sensors to measure respective changes in distances between the proximity sensors and the sample surface; and use the generated sample surface topographical map to control the position and/or orientation of the sample during processing of the sample by the beam grid, wherein the position and/or orientation of the sample is controlled to move through a continuous range of different positions and/or orientations during the processing.

According to an aspect of the invention, there is provided an assessment apparatus for assessing a sample using a plurality of charged particle beams, comprising: a sample support configured to support a sample, the sample having a sample surface; a charged particle device configured to project a beam grid of a plurality of charged particle beams along a grid path of the beam grid towards the sample; a plurality of proximity sensors configured to face the sample, desirably positioned spaced away from the grid path, each proximity sensor configured to measure a distance between the proximity sensor and the sample; and a control system configured to: generate a sample surface topographical map representing a topography of the sample surface by controlling the sample support to move the sample through a range of sample positions relative to the charged particle device while using the proximity sensors to measure respective changes in distance between the proximity sensors and the sample surface; use the generated sample surface topographical map to control positioning of the sample during processing of the sample by the beam grid; and receive a sample support topographical map representing a topography of the sample support and to use the received sample support topographical map either: to determine a calibrated sample surface topographical map, wherein desirably the using of the generated sample surface topographical map to control positioning of the sample uses the calibrated sample surface topographical map; or to calibrate the generation of the sample surface topographical map, desirably so that the generated sample surface topographical map is calibrated by the sample support topographical map.

According to an aspect of the invention, there is provided a method of assessing a sample using a plurality of charged particle beams, comprising: scanning at least a subset of a beam grid of a plurality of charged particle beams and respective target portions of a sample surface relative to each other, so as to process the target portions with the beams; detecting signal charged particles from the sample and generating detection signals on detection of the signal charged particles; and generating a sample surface topographical map representing a topography of the sample surface by analyzing detection signals detected in response to the scanning of the at least a subset of the beam grid and respective target portions relative to each other.

According to an aspect of the invention, there is provided a method of assessing a sample using a plurality of charged particle beams, comprising: importing an externally-derived topographical map representing a topography of a sample surface of a sample measured using an external device; and processing the sample using a beam grid of a plurality of charged particle beams while controlling a positioning of the sample using the externally-derived topographical map and output data from a plurality of proximity sensors measuring distances to the sample from the proximity sensors.

According to an aspect of the invention, there is provided a method of assessing a sample using a plurality of charged particle beams, comprising: receiving a sample support topographical map representing a topography of a surface of a sample support supporting a sample; and processing the sample using a beam grid of a plurality of charged particle beams while controlling a positioning of the sample using the sample support topographical map and output data from a plurality of proximity sensors measuring distances to the sample from the proximity sensors.

According to an aspect of the invention, there is provided a method of assessing a sample using a plurality of charged particle beams, comprising: optically measuring a topographical map representing a topography of a sample surface of a sample; and using the measured topographical map to control a positioning of the sample during processing of the sample by a beam grid of a plurality of charged particle beams.

According to an aspect of the invention, there is provided a method of assessing a sample using a plurality of charged particle beams, comprising: generating a sample surface topographical map representing a topography of a sample surface of a sample by moving the sample through a range of positions and/or orientations while using proximity sensors to measure respective changes in distances between the proximity sensors and the sample surface; and using the generated sample surface topographical map to control the position and/or orientation of the sample during processing of the sample by a beam grid of a plurality of charged particle beams, wherein the position and/or orientation of the sample is controlled to move through a continuous range of different positions and/or orientations during the processing.

According to an aspect of the invention, there is provided a method of assessing a sample using a plurality of charged particle beams, comprising: generating a sample surface topographical map representing a topography of a sample surface of a sample by moving the sample through a range of sample positions while using proximity sensors to measure respective changes in distance between the proximity sensors and the sample surface; using the generated sample surface topographical map to control positioning of the sample during processing of the sample by a beam grid of a plurality of charged particle beams; and receiving a sample support topographical map representing a topography of a sample support supporting the sample and using the received sample support topographical map either: a) to determine a calibrated sample surface topographical map, wherein desirably the using of the generated sample surface topographical map to control positioning of the sample uses the calibrated sample surface topographical map; or b) to calibrate the generation of the sample surface topographical map, desirably so that the generated sample surface topographical map is calibrated by the sample support topographical map.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1****.**
**FIG. 3** is a schematic diagram of an exemplary electron-optical column comprising a condenser lens array, an objective lens array and a detector array.
**FIG. 4** is a schematic cross-sectional view of a portion of an objective lens array and detector array of an exemplary arrangement.
**FIG. 5** is bottom view of the portion of the detector array of **FIG. 4****.**
**FIG. 6** is a bottom view of a modified version of the portion of the objective lens array of **FIG. 4****.**
**FIG. 7** is a schematic diagram of an exemplary electron-optical device comprising an objective lens array and a beam separator.
**FIG. 8** is a schematic bottom view of a beam grid and proximity sensors.
**FIG. 9** is a schematic side view of a portion of a sample down-beam of an arrangement of the type shown in **FIG. 8****.**
**FIG. 10** depicts an example spatial distribution of target portions on the sample surface.
**FIG. 11** schematically depicts charged particle beams having a common focal plane and three example positions of a portion of a sample corresponding to different focus condition settings.
**FIG. 12-15** schematically depicts different focal plane positions for a fixed sample position, the different focal plane positions corresponding to different focus condition settings.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000^{th} of a human hair. Thus, it is not surprising that semiconductor IC manufacturing is a complex and time-consuming process, with hundreds of individual steps. Errors in even one step have the potential to dramatically affect the functioning of the final product. Even a single defect can cause device failure in certain situations. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical device or column. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

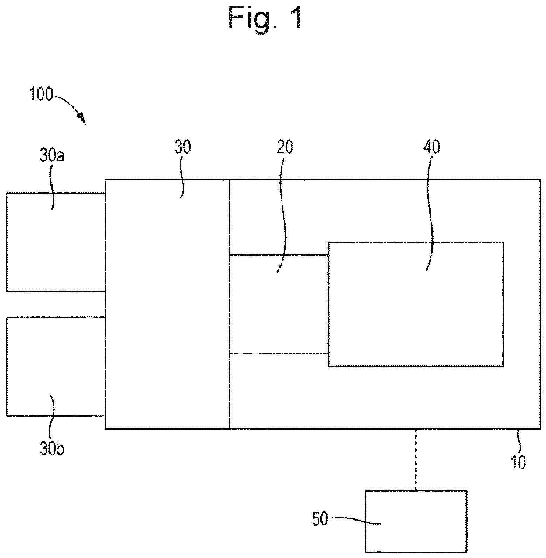

Reference is now made to **FIG. 1****,** which is a schematic diagram illustrating an exemplary charged particle beam inspection apparatus 100, which may also be referred to as a charged particle beam assessment system or simply assessment system. The charged particle beam inspection apparatus 100 of **FIG. 1** includes a main chamber 10, a load lock chamber 20, an electron beam apparatus 40, an equipment front end module (EFEM) 30 and a controller 50. The controller may be distributed between different components of the assessment system, including for example in the electron beam apparatus 40. Electron beam apparatus 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam apparatus by which it may be inspected. An electron beam apparatus 40 may comprise a multi-beam electron-optical apparatus.

Controller 50 is signally, for example electronically, connected to electron beam apparatus 40, for example as distributed components of the controller 50. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection apparatus, it should be noted that aspects of the disclosure in their broadest sense are not limited to a chamber housing an electron beam inspection apparatus. Rather, it is appreciated that the foregoing principles may also be applied to other systems and other arrangements of apparatus, that operate under the second pressure.

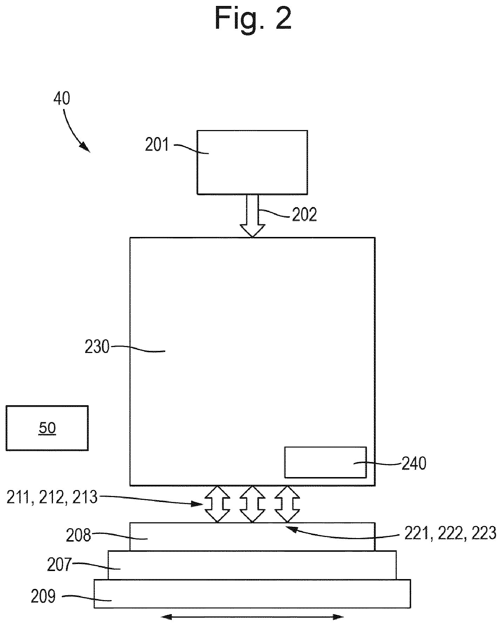

Reference is now made to **FIG. 2****,** which is a schematic diagram illustrating an exemplary charged particle beam assessment apparatus 40. The electron beam apparatus 40 may be provided as part of the exemplary charged particle beam inspection system 100 of **FIG. 1****.** The electron beam apparatus 40 includes an electron source 201 and a charged particle column (or device) 230. The charged particle device 230 may be referred to or comprise a projection apparatus for directing a primary charged particle beam 202 towards a sample 208. The electron source 201 and associated and component charged particle optical elements may be referred to as an illumination apparatus for generating a primary charged particle beam 202. The assessment apparatus comprises a sample support that supports a sample 208. The sample support in this example comprises a sample holder 207. The sample holder 207 holds the sample 208 (e.g., a substrate or a mask) for assessment. The sample holder 207 is supported by a motorized or actuated stage 209. The electron beam apparatus 40 further comprises a detector 240. The detector 240 detects signal charged particles (e.g., electrons) from the sample 208. The detector 240 generates detection signals on detection of the signal charged particles.

The electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form the primary electron beam 202.

The charged particle device 230 is configured to convert primary electron beam 202 into a plurality of charged particle beams 211, 212, 213 and to direct each beam onto the sample 208. Although three beams are illustrated for simplicity, there may be many tens, many hundreds, many thousands, many tens of thousands, or even hundreds of thousands (or more) of beams. The beams may be referred to as beamlets or sub-beams. The plurality of charged particle beams may be referred to collectively as a multi-beam or beam grid. A beam grid with so many beams (e.g. more than a thousand beams) may have a field of view of e.g. more than 0.5mm, for example in the range of 0.5 to 30mm or 1 to 30 mm, for example in the range of 0.5 to 15mm.

The controller 50 (for example control system comprising distributed controllers) may be connected to various parts of charged particle beam inspection apparatus 100 of **FIG. 1****,** such as the electron source 201, the electron detection device 240, the charged particle device 230, and actuated stage 209. The controller 50 may perform various image and signal processing functions. The controller 50 may also generate various control signals to govern operations of the charged particle beam inspection apparatus 100, including operations of the electron beam apparatus 40.

The charged particle device 230 may be configured to focus, for example, beams 211, 212, and 213 onto a sample 208 for inspection and may form three probe spots 221, 222, and 223 on the surface of sample 208. The charged particle device 230 may be configured to deflect primary beams 211, 212, and 213 to scan probe spots 221, 222, and 223 across individual scanning areas in a section of the surface of sample 208. In response to incidence of primary beams 211, 212, and 213 on probe spots 221, 222, and 223 on sample 208, electrons are generated from the sample 208 which include secondary electrons and backscattered electrons which may be referred to as signal charged particles. The secondary electrons typically have electron energy as large as fifty electron volts (≤ 50 eV) and backscattered electrons typically have electron energy between fifty electron volts (50 eV) and the landing energy of primary beams 211, 212, and 213.

The detector 240 may send the detection signals generated in the detector 240, for example as an imaging or detection signal, to the controller 50 or a signal processing system (not shown which may be part of the controller 50), e.g. to construct images of the corresponding scanned areas of sample 208. The detector 240 may be incorporated at least partly into the charged particle device 230 or may be separate therefrom, for example where a secondary optical column directs secondary electrons to the detector 240.

The controller 50 may comprise an image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive the detection signal from the detector 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample 208 based on an imaging signal received from the detector 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. A part of the controller for such a function may be comprised in or proximate to the detector. The electron distribution data, collected during a detection time window, can be used in combination with corresponding scan path data of each of primary beams 211, 212, and 213 incident on the sample surface to reconstruct images of the sample structures under inspection. The reconstructed images can be used to reveal various features of the internal or external structures of sample 208. The reconstructed images can thereby be used to reveal any defects that may exist in and/or on, thus of the sample.

The controller 50 may control actuated stage 209 to move sample 208 during inspection of sample 208, for example to provide a scanning motion of the stage relative to the paths of the primary beams. The controller 50 may enable actuated stage 209 to move sample 208 in a direction such as part of the scanning motion of the stage, preferably continuously, for example at a constant speed, at least during sample inspection. The controller 50 may control movement of the actuated stage 209 so that it changes the speed of the movement of the sample 208 dependent on various parameters. For example, the controller may control the stage speed (including its direction) depending on the characteristics of the inspection steps and/or scans of the scanning process for example as disclosed in EPA 21171877.0 filed 3 May 2021 which is hereby incorporated by reference in so far as the combined stepping and scanning strategy at least of the stage. In controlling the actuated stage, actuation of the stage and thus the sample may enable the sample to be positioned, for example dynamically, relative to the paths of the primary beams.

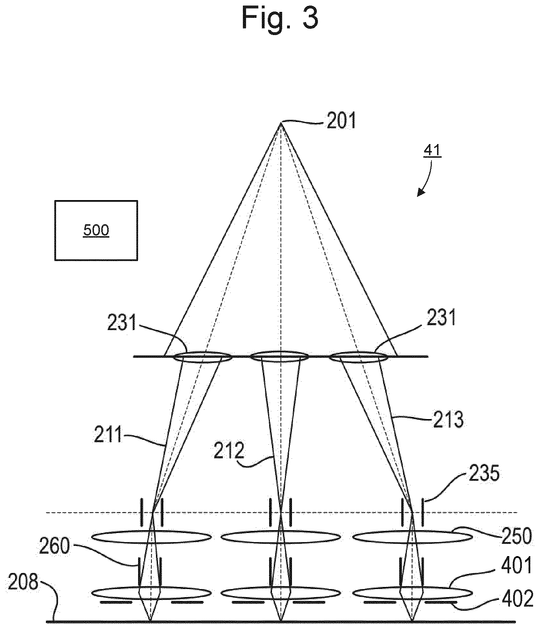

**FIG. 3** is a schematic diagram of an exemplary charged particle device 41 for use in an assessment apparatus. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged particle devices such as those discussed herein, it will be understood that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along a path of a beam grid of a plurality of charged particle beams (which may also be referred to as sub-beams). The electrodes are thus also in series along paths of charged particle beams of the beam grid.

Electron source 201 directs electrons toward an array of condenser lenses 231 forming part of charged particle device 230. The electron source 201 is desirably a high brightness thermal field emitter with a good compromise between brightness and total emission current. There may be many tens, many hundreds or many thousands or even tens of thousands of condenser lenses 231. Condenser lenses of array 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array may take the form of at least two, preferably three, plates, acting as electrodes, with apertures in each plate aligned with apertures in other plates to define paths for charged particle beams through the plates. At least two of the plates are maintained during operation at different potentials to achieve the desired lensing effect. Between the plates of the condenser lens array are electrically insulating plates, for example made of an insulating material such as ceramic or glass, with one or more apertures for the charged particle beams. Additionally or alternatively, one or more of the plates may feature apertures that each have their own electrode, for example with an array of electrodes around their perimeter or arranged in groups of apertures having a common electrode. In a variant, one or more of the plates may comprise multiple portions or strips with multiple apertures. In a further alternative arrangement, a macro collimator is provided instead of the condenser lens array. The macro collimator may act on the beam from the source 201 before the beam has been split into a multi-beam. The macro collimator may be implemented magnetically, electrostatically, or magnetically and electrostatically.

In some embodiments, the condenser lens array is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective beam 211, 212, 213 which is focused at a respective intermediate focus 233. A collimator or an array of collimators may be positioned to operate on the respective intermediate focuses 233. The collimators may take the form of deflectors 235 provided at the intermediate focuses 233. Deflectors 235 are configured to bend a respective beam 211, 212, 213 by an amount effective to ensure that the principal ray (which may also be referred to as the beam axis) is incident on the sample 208 substantially normally (i.e. at substantially 90° to the nominal surface of the sample). Note that in an arrangement with a macro condenser lens, the condenser lens may collimate or contribute to the collimation of the source beam or, in an embodiment, a plurality of beams.

An objective lens array 401 is provided down-beam from the deflectors 235. The objective lens array 501 comprises an objective lens for each beam 211, 212, 213. The objective lens array 401 projects the beams 211, 212, 213 onto the sample 208. The objective lens array 401 may comprise two or more, preferably at least three, plate electrode arrays connected to respective potential sources.

Optionally, a control lens array 250 is provided between the deflectors 235 and the objective lens array 401. The control lens array 250 comprises a control lens for each beam 211, 212, 213. The control lens array 250 provides additional degrees of freedom for controlling properties of the beams 211, 212, 213. The control lens array 250 may comprise two or more, preferably at least three, plate electrode arrays connected to respective potential sources. A function of control lens array 250 is to optimize the beam opening angle with respect to the demagnification of the beam and/or to control the beam energy delivered to the objective lenses, each of which directs a respective beam 211, 212, 213 onto the sample 208. In an embodiment the control lens array may be considered to be part of the objective lens, for example in being additional plates associated with the objective lens array.

Optionally an array of scan deflectors 260 is provided between the control lens array 250 and the objective lens array 401. The array of scan deflectors 260 comprises a scan deflector for each beam 211, 212, 213. Each scan deflector is configured to deflect a respective beam 211, 212, 213 in one or two directions to scan the beam across the sample 208 in one or two directions. Alternatively, a macro scan deflector may be provided to scan the charged particle beams over the sample 208. The macro scan deflector may be provided up-beam of the control lens array 250. In an embodiment such a macro scan deflector may operate on the source beam and may be present with a macro condenser lens.

A detector module 402 of a detector is provided within the objective lenses or between the objective lenses and the sample 208 to detect signal electrons/particles from the sample 208. An exemplary construction of such a detector module 402 is described below. Note that the detector additionally or alternatively may have detector elements up-beam along the primary beam path of the objective lens array 401 or even the control lens array 250. The detector module may be an array of detector elements (e.g. a detector array). Each element may be associated with an individual beam, for example positioned to detect signal particles generated by the individual beam.

The charged particle device 41 of FIG. 3 may be configured to control the landing energy of electrons on the sample 208 by varying potentials applied to the electrodes of the control lenses and the objective lenses. The control lenses and objective lenses work together and may be referred to as an objective lens assembly. The landing energy can be selected to increase emission and detection of secondary electrons dependent on the nature of the sample being assessed. The detector module may be comprised in the objective lens assembly.

The objective lenses can be configured to demagnify the electron beam by a factor greater than 10, desirably in the range of 50 to 100 or more. The objective lenses may comprise three electrodes: a middle electrode, a lower electrode and an upper electrode. The upper electrode may be omitted. An objective lens having only two electrodes can have lower aberration than an objective lens having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beams.

In some embodiments, the objective lens array assembly comprises a detector having a detector module 402 down-beam of at least one electrode of the objective lens array 401. The detector module 402 may comprise or even take the form of a detector array. In an embodiment, at least a portion of the detector is adjacent to and/or integrated with the objective lens array 401. For example, the detector module 402 may be implemented by integrating a CMOS chip detector into a bottom electrode of the objective lens array 401. Integration of a detector module 402 into the objective lens array may replace a secondary column. The CMOS chip is preferably orientated to face the sample (because of the small distance between sample and the bottom of the electron-optical system, which may for example be in the range of 10 to 400 micron, desirably in the range of 50 to 200 micron, optionally about 100 micron). It is noted that even in situations in which the detector is up-beam of the most down-beam electron-optical element of the charged particle device, there may be a close, e.g. of similar distance, separation between the most down-beam electron-optical element and the sample (e.g. about 100 micron). In an embodiment, electrodes to capture the signal charged particles are formed in the top metal layer of the CMOS device. The electrodes can be formed in other layers of the substrate, e.g. of the CMOS chip. Power and control signals of the CMOS may be connected to the CMOS by through-silicon vias. For robustness, preferably the bottom electrode consists of two elements: the CMOS chip and a passive Si plate with holes. The plate shields the CMOS from high E-fields.

In an embodiment, a single electrode surrounds at least some of the apertures. In an arrangement a single electrode is assigned for example around each aperture. In another embodiment, a plurality of electrode elements are provided around each aperture for example as a detector element. The signal charged particles captured by the electrode elements surrounding one aperture may be combined into a single detection signal or used to generate independent detection signals. The electrode elements may be divided radially (i.e., to form a plurality of concentric annuluses), angularly (i.e., to form a plurality of sector-like pieces), both radially and angularly (providing an arrangement like a dart board), or in a grid (for example as a chess board) or in any other convenient manner.

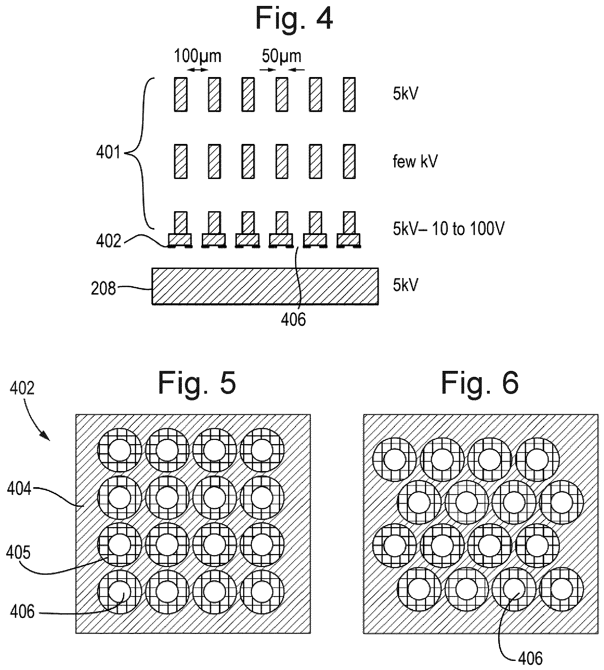

An exemplary embodiment of a detector integrated into an objective lens array 401 is shown in FIG. 4, which illustrates a portion of an objective lens array 401 in schematic cross section. In this embodiment, the detector comprises a detector module 402 comprising a plurality (e.g., an array) of detector elements 405 (e.g., sensor elements such as capture electrodes) preferably as an array of detector elements (i.e. a plurality of detector elements in a pattern or arrangement preferably over a two dimensional surface). In this embodiment, the detector module 402 is provided on an output side of the objective lens array. The output side is the output side of the objective lens array 401. **FIG. 5** is a bottom view of detector module 402 which comprises a substrate 404 on which are provided a plurality of detector elements (or capture electrodes 405) each surrounding a beam aperture 406. The beam apertures 406 may be formed by etching through substrate 404. In the arrangement shown in **FIG. 5****,** the beam apertures 406 are shown in a rectangular array. The beam apertures 406 can also be differently arranged, e.g. in a hexagonal close packed array as depicted in **FIG. 6****.**

The integrated detector module 402 described above is particularly advantageous when used with an assessment apparatus (e.g. comprising a device) having tunable landing energy because secondary electron capture can be optimized for a range of landing energies. A detector module having or in the form of an array can also be integrated into other electrode arrays, not only the lowest electrode array. Further details and alternative arrangements of a detector module integrated into an objective lens can be found in EP Application Number 20184160.8, which document is hereby incorporated by reference.

An electric power source may be provided to apply respective potentials to electrodes of the control lenses of the control lens array 250 and the objective lenses of the objective lens array 401 and the condenser lenses of the condenser lens array or any electron-optical component of the charged particle device 41 for example the detector module (such as when integrated into the objective lens array or when the objective lens and detector module are separate components). A controller 50 may control the potentials applied to the electron-optical components such as the electrodes of the condenser lens array, objective lens array and/or control lens array.

The charged particle device 41 may comprise other electron-optical components such as charged particle correctors, for example as corrector arrays for alignment of the source to the sample and between beams of the multi-beam and for adjusting the focus of different groups of the beam grid, or individual beams of the beam grid. Such correctors may be controlled to operate dynamically and/or statically, for example during step-up, servicing or during calibration of the charged particle device 41.

In an embodiment, an array of charged particle devices (or device array) is provided. The array may comprise a plurality of any of the charged particle devices (e.g., electron-optical columns) described herein. Each of the charged particle devices in the array focuses respective pluralities of charged particle beams onto different regions of the same sample 208. Each charged particle device in the array may derive a respective plurality of charged particle beams from a different respective source 201. Each respective source 201 may be one source in a plurality of sources 201. At least a subset of the plurality of sources 201 may be provided as a source array. The source array may comprise a plurality of emitters on a common substrate. The focusing of pluralities of charged particle beams from different charged particle devices simultaneously onto different regions of the same sample allows an increased area of the sample 208 to be exposed to charged particle beams simultaneously. Therefore, an increased area of the sample may be processed (e.g. assessed) at one time. The charged particle devices in the device array may be arranged adjacent to each other so as to project the respective pluralities of beams onto adjacent regions of the sample 208. Any number of charged particle devices may be used in the array. Preferably, the number of charged particle devices is in the range of 9 to 200. Each charged particle device in the array may be configured in any of the ways described herein when referring to a single charged particle device, electron-optical device or system or column. Alternatively or additionally, one or more of the charged particle device in the array may be configured to project a single beam.

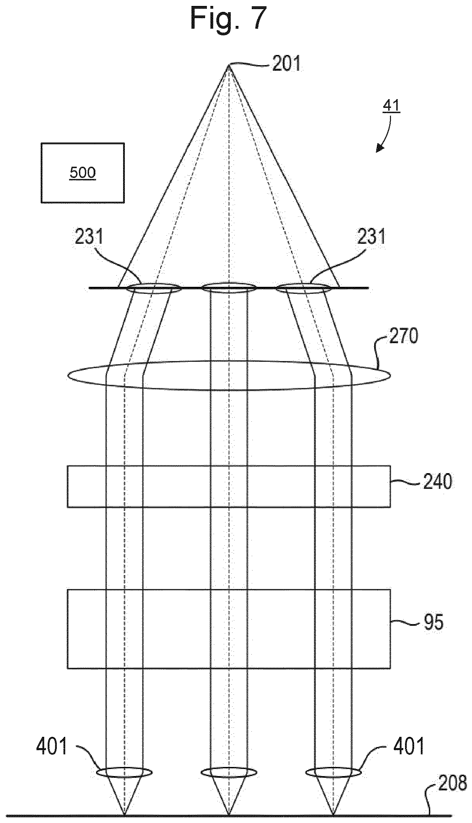

**FIG. 7** schematically depicts a further example of a charged particle device 41. Features that are the same as those described above are given the same reference numerals. For conciseness, such features are not described in detail with reference to **FIG. 7****.** For example, the source 201, the condenser lenses 231, the objective lens array 401 and the sample 208 (e.g., on a sample support 207) may be as described above. In this example, a macro collimator 270 is provided instead of a deflector array of the type described above with reference to **FIG. 3****.** Such a macro collimator may be a macro lens that may be magnetic, electrostatic or both. In other embodiments, a deflector array may be used to at least contribute to the collimation of the beams, so the deflector array is for finer deflection towards collimation than the action of the macro collimator 270. Such an arrangement may also comprise an array of multiple deflectors (for example in which each aperture has multiple electrodes) for even finer collimation. In an arrangement the condenser lenses 231 may comprise a single plate defining a beam limiting aperture array in which are defined a plurality of apertures with one or more associated macro electrodes with a single aperture. Such a beam limiting aperture array and an associated macro electrode may also form a condenser lens array to focus the generated beams in an intermediate focus which desirably corresponds to the position of the collimator 270.

As described above, in some embodiments a detector may be provided between the objective lens array 401 and the sample 208. The detector may face the sample 208. Alternatively, as shown in FIG. 7, the detector 240 may be implemented such that the objective lens array 401 is between the detector 240 and the sample 208.

In an embodiment a deflector array 95 is provided between the detector 240 and the objective lens array 401. In an embodiment the deflector array 95 comprises a Wien filter array so that deflector array 95 may be referred to as a beam separator. The deflector array 95 is configured to provide a magnetic field and an electrostatic filed. The electrostatic and magnetic fields operate together to separate the charged particles projected to the sample 208 relative to the signal particles e.g. electrons from the sample 208. The operation of the fields directs the signal particles towards the detector 240.

In an embodiment the detector 240 is configured to detect signal particles by reference to the energy of the charged particle, i.e. dependent on a band gap, such a semiconductor based type of detector. Such a detector 240 may be called an indirect current detector. The secondary electrons emitted from the sample 208 gain energy from the fields between the electrodes. The secondary electrons have sufficient energy once they reach the detector 240. In a different arrangement the detector 240 may be an electron to photon converter such as a scintillator array, for example of fluorescing strip between the beams that are positioned up beam along the primary beam path with respect to the Wien filter. Primary beams passing through the Wien filter array (of magnetic and electrostatic strips orthogonal to the primary beam path) have paths upbeam and downbeam of the Wien filter array that are substantially parallel, whereas signal electrons from the sample are directed by the Wien filter array towards the scintillator array. The electron to photon converter may be photonically coupled to a photon to electron converter to convert any photons generated in and emitted by the electron to photon converter. The photon to electron converter may be electrically connected to electronic circuitry to process a detection signal. In different embodiments the photon to electron converter may be within or external to the charged particle device. In an embodiment photon coupling may be by via a photon transport unit (e.g., an array of optical fibers) to a remote optical detector which generates a detection signal on detection of a photon.

As mentioned in the introductory part of the description, projecting a plurality of charged particles onto a sample increases throughput relative to a single beam but makes focus control more challenging. The plurality of charged particles may be referred to as a beam grid. The quality of focus of each beam on the sample surface is determined by the position of the focal plane of the beam relative to the position on the sample surface where the beam is incident. (Note although reference in this text generally is to a focal plane of beam and a focal plane a plurality of beams, the beam grid or a selection of beams of the beam grid, it is understood that the focal plane of a single beam may be expressed as a focal point). If the position of the focal plane is within an acceptable range of the corresponding portion of the sample surface the quality of focus will be acceptable. Controlling the position of the focal plane for each beam relative to the sample surface is challenging because of the typically non-planar topography of the sample surface and the relatively large size of the area of intersection between a path (which may be referred to as a grid path) of the beam grid and the sample.

At the time of the drafting of this description, the variation in the displacement of the sample surface away from or out of the plane of the sample surface (e.g., orthogonal to the plane of the sample surface) may be around 50 micron, for example 20 to 40 micron. This may be a notable proportion of an average distance between the sample surface and the facing surface of the charged particle device 41, for example the detector 240. Where the field of view of the charged particle device 41 is relatively large, for example 0.5 to 300 mm, a size of the range of variation in the distance of the sample surface to the facing surface of the charged particle device 41 over the field of view may be in the full range, or at least a significant part, of the variation in the displacement of the sample surface away from or out of the plane of the sample surface. However, for operation of the assessment apparatus the beams of the beam grid ideally are in focus on the sample surface on which they are incident.

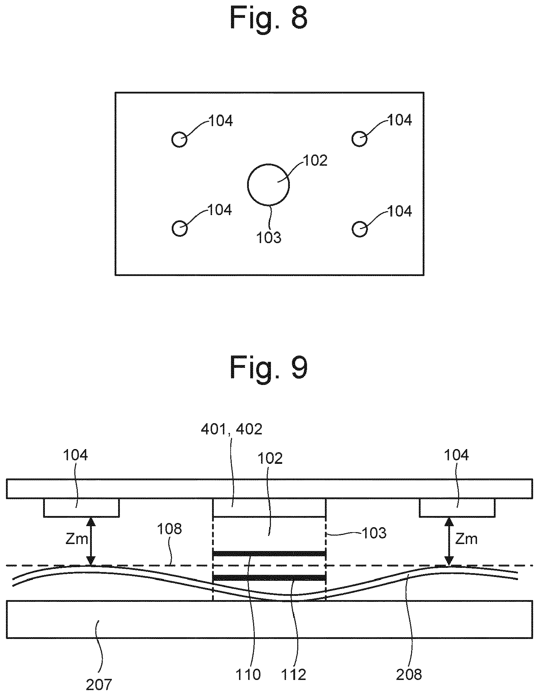

It is possible to obtain information about the topography of the sample surface using proximity sensors. **FIG. 8** is a schematic bottom view (looking in an up-beam direction) of a beam grid 102 of a plurality of charged particle beams. The beam grid 102 may have any shape, including rectangular or hexagonal. The beam grid 102 has a path 103, which defines the radially outermost limits of the beam grid 102. All of the beams of the beam grid 102 are contained within the path 103. The path 103 thus defines a volume between the charged particle device and the sample 208 that contains the beams. No beams are present outside the path 103. In this example, four proximity sensors 104 are provided outside of the path 103 of the beam grid 102. The proximity sensors 104 may be described as being positioned spaced away from the path 103 of the beam grid 102. Proximity sensors 104 may be positioned outside of the path 103 due to a lack of space to position proximity sensors inside the path 103. Each proximity sensor 104 faces the sample 208 and is capable of measuring a distance Zm between the proximity sensor 104 and the sample 208 (e.g., the distance between the proximity sensor 104 and a portion of the sample surface facing the proximity sensor 104). Each proximity sensor 104 provides output data representing a result of the measurement. In some arrangements each proximity sensor 104 comprises one or more capacitive sensors, optionally configured to operate in differential mode. The output data from the proximity sensors 104 can be used to control positioning of the sample 208 (including both position and orientation, for example rotational displacement relative to, for example about, an axis of a coordinate system of the beam grid and/or sample) to improve a quality of focus of the charged particle beams of the beam grid 102 on the sample 208. The aim is to position the portion of the sample surface processed by each beam at or near the position of the focal plane for that beam.

**FIG. 9** is a schematic side view of a portion of a sample 208 down-beam of an arrangement of the type shown in **FIG. 8****.** In this case, the beam grid 102 is projected along grid path 103 from electron-optics of the charged particle device providing the beam grid 102 (which may include an objective lens array 401 comprising objective lenses and/or a detector module 402 of a detector, as discussed above with reference to **FIG. 1-7****).** In the example shown, the beam grid 102 has a common focal plane 108 for all charged particle beams of the beam grid 102. The quality of focus will be acceptable for a range of positions of the sample surface close to the position of the focal plane 108. The range of positions may be defined by an upper limit 110 and a lower limit 112, as depicted schematically in **FIG. 9. FIG. 9** shows how variations in the topography of the sample 208 (which may be referred to as unflatness) may cause focus problems. Such variations in the topography of the sample may be considered to be variations of displacement of the surface of the sample away from an ideal plane of the sample surface, which may be substantially parallel to a plane of the sample support, or at least an ideal sample position on the sample support. Variations in the topography of the sample 208 may cause focus problems even if the proximity sensors 104 indicate that the sample 208 is perfectly positioned, i.e. with the sample surface at the focal plane 108. In such a situation the proximity sensors 104 indicate that the portions of the sample surface opposite the proximity sensors 104 are positioned at the focal plane 108, rather than the sample surface away from those portions, such as the portion of the sample surface within the grid path 103. The topography of the sample 208 is likely to cause the portion of the sample surface within the grid path 103 to be positioned outside of the range of positions that yield an acceptable quality of focus while the portions of the sample surface opposite the proximity sensors 104 are positioned at the focal plane 108. Depending on the direction and form of curvature of the sample surface in the grid path 103 (e.g. convex, concave), the sample surface may be entirely below or above the range of positions defined by the upper limit 110 and the lower limit 112 or the portion of the sample surface in the grid path 103 may pass through the focus of the beam grid with only portions of the sample surface being positioned above and/or below the upper and lower limits. Embodiments of the disclosure described below aim to address such situations.

In some embodiments, an assessment apparatus is provided. The assessment apparatus is configured to be suitable for assessing (e.g., inspecting for defects, or measuring of sample features) a sample 208 using a plurality of charged particle beams. The plurality of charged particle beams may be referred to as a beam grid. The assessment apparatus comprises a sample support for supporting the sample 208. The sample support may take any of the forms described above with reference to **FIG. 2****.** The sample support may comprise a sample holder 207 and/or a motorized stage 209 for example. The sample support is controllable to adjust a position and/or orientation of the sample 208, for example at least one degree of freedom. The assessment apparatus comprises a charged particle device that projects the beam grid 102 along a grid path 103 of the beam grid 102 towards the sample 208, for example as depicted schematically in **FIG. 9****.** The charged particle device may take any of the forms described above for the charged particle device 41 (which may also be referred to as an electron-optical device or electron-optical column) with reference particularly to **FIG. 3** and **7****.** The assessment apparatus comprises a detector. The detector detects signal charged particles from the sample 208. The detector generates detection signals on detection of the signal charged particles. The detector may take any of the forms described above for the detector 240 with reference particularly to **FIG. 2-7****.** The detector may comprise a detector module 402 as described particularly with reference to **FIG. 3-6****.** The detector may comprise an array of detector elements, optionally with an individual detector element for each beam of the beam grid.

In some embodiments, the assessment apparatus further comprises a control system 500. The control system 500 controls the assessment apparatus to perform various functions as described below. The control system 500 may comprise or consist of a controller 50 taking any of the forms described above with reference to **FIG. 1****.** The control system 500 may cause the assessment apparatus to perform the functions by controlling the sample support, the charged particle device and/or the detector. The control system 500 may comprise a single unit configured to perform all of the control functionality or may comprise a distributed system of units that together allow the required functionalities to be achieved. Such a distributed system may have one or more elements located in and/or associated with different components or modules of the assessment apparatus such as, in a non-limited list, the motorized stage 209 and the charged particle device 41. The control system 500 may be at least partially computer implemented. Any suitable combination of elements (e.g., CPUs, RAM, data storage, data connections, sensors, etc.) may be provided and suitably programmed to achieve some or even all the specified functionality. Any reference herein to an apparatus, device or system being configured to perform functionality is intended to encompass the case where the control system 500 is configured to cause the functionality to be performed (e.g., by being suitably programmed to provide control signals that cause the functionality to happen).

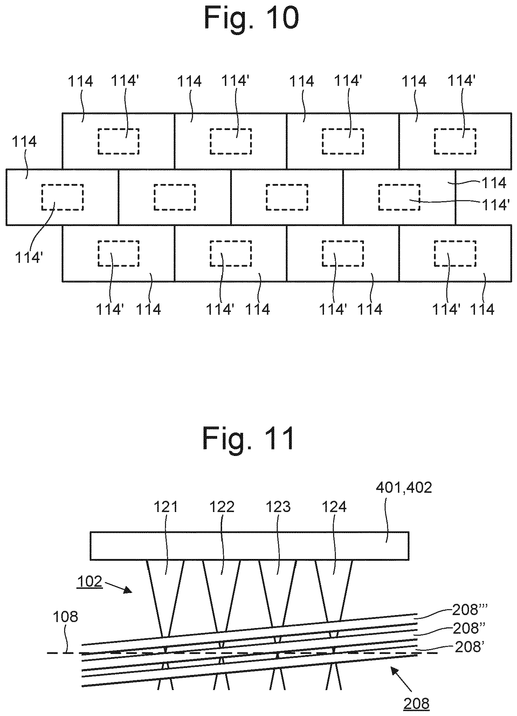

In an embodiment, the control system 500 controls the sample support and/or the charged particle device to scan at least a subset of the beam grid 102 and respective target portions 114 of the sample surface relative to each other. Thus, a charged particle beam of the beam grid (or at least a subset of the beam grid 102) may have a corresponding target portion 114. An example spatial distribution of target portions 114 is shown in **FIG. 10** (described below). All of the charged particle beams in the beam grid 102 may be scanned over their respective target portions 114 or less than all (a subset) may be scanned over their respective target portions 114. In some arrangements, a subset of the beam grid (i.e., a subset of the available charged particle beams) is selected with reference to a predetermined topographical map of the sample surface. The subset may be selected for example to avoid regions on the sample surface that are damaged or which have local topography which departs too much from an average topography (e.g., particularly tall peaks or deep troughs).

A portion of the sample surface which has a local topography which departs too much from an average topography is positioned relative to the paths of the beams of the selected subset of the beam grid 102 (or a number of the beams of the selected subset) such that the portion of the sample surface is too far from the focal plane of the respective beams of the selected subset to be in focus. That is the position of the sample surface is a distance which exceeds a focus threshold along the paths of the respective beams of the selected subset from the focal plane of the respective beams. The selected subset may comprise a contiguous portion of the beam grid 102. A contiguous portion of the beam grid 102 consists of a portion of the beam grid in which all charged particle beams are directly adjacent to at least one other charged particle beam in the selected subset. The selected subset may alternatively or additionally comprise a distribution of groups of one or more charged particle beams, with each group being separated from the other groups by one or more charged particle beams that are outside of (not part of) the subset. Selection of the subset may be achieved by one or more of the following (in a non-limited list): blanking unselected beams of the beam grid so that they do not reach the sample; controlling a detector to be in a non-transmission setting in which the detector does not transmit a detection signal; deselecting a detection signal from a detector associated with an unselected beam from processing; or selecting detection signals only from detector elements associated with selected beams of the beam grid.

The scanning of a charged particle beam over the target portion 114 (i.e., the target portion 114 corresponding to that charged particle beam), or the dynamic intersection of a path of a charged particle beam over the surface of the target portion 114, may be referred to as processing of that target portion 114. The target portion 114 may have any desired and suitable shape. In an embodiment the target portions 114 may be rectangular. Signal electrons travelling from the target portion 114 during the processing may be detected by the detector and used to generate an image of the target portion 114, for example using an image acquirer as described above.

The shapes and spatial distribution of the target portions 114 on the sample surface are not particularly limited. **FIG. 10** depicts one possible arrangement of target portions 114 for 12 adjacent charged particle beams of a beam grid. Three rows of four target portions 114 are shown, but the beam grid will typically simultaneously process many more target portions 114 than this, for example hundreds or thousands of target portions 114. In this example, each target portion 114 is processed by a different charged particle beam of the beam grid. The targets portions 114 may be processed at the same time by the different charged particle beams. The processing may comprise scanning each charged particle beam over the respective target portion 114, for example in a raster scan. In this example each target portion 114 is fully processed and the resulting processed target portions 114 form a single contiguous processed region with no gaps between the processed target portions 114. In other arrangements, the target portions 114 may be processed to leave gaps between different processed regions. In an embodiment the target portions 114 may be rectangular and rectangular regions corresponding in shape but smaller may be processed. This is exemplified in **FIG. 10****,** where each of the rectangular regions corresponding to a target portion 114 is only partially processed. Thus, a part of each target portion 114 of the sample surface is processed that consists of only a portion of the region that could be processed in the target position 114. Such a portion of the region is the partial region labelled 114' in each target portion 114. The parts of the target portions 114 that are processed as the partial regions 114' may be any parts of the sample surface within the target portions 114. Note that the part of each target portion 114 that is scanned, i.e. the partial region 114', is a similar portion of the sample surface for each target portion 114, for example similar in size and/or location within the target portion 114. Such partial processing of the sample surface may improve efficiency, for example by increasing stability, which can improve throughput by reducing the overall time required for scanning.

The control system 500 is configured to generate a sample surface topographical map. The generated sample surface topographical map represents a topography of the sample surface, optionally in the reference frame of the charged particle device. The sample surface topographical map may thus provide information about the shape of the sample surface that faces the charged particle device in the reference frame of the charged particle device, e.g. variations in the flatness, or variations of displacements of the sample surface (e.g., away from an ideal plane of the sample surface). The control system 500 generates the sample surface topographical map by analyzing detection signals from the detector. The detection signals are detected in response to the scanning of the at least a subset of the beam grid 102 and respective target portions 114 relative to each other. Thus, a detection signal may be provided for each of the target portions 114 scanned by a charged particle beam. Using information from the scanning of the charged particle beams themselves (instead of or in addition to information from proximity sensors 104 outside of the path 103 of the beam grid 102) allows detailed information to be obtained about the sample surface topography. The generated sample surface topographical map may, for example, provide the basis for controlling positioning of the sample 208 and/or operation of the charged particle device more effectively than as described with reference to **FIG. 9****.** In particular, it is possible to improve on the approach of merely positioning the sample 208 to ensure the sample surface coincides with the focal plane 108 at positions corresponding to the proximity sensors 104 (outside of the beam grid 102).

For example, in some embodiments the control system 500 uses the generated sample surface topographical map during a subsequent processing of the sample 208 using the beam grid 102. The subsequent processing may comprise an assessment process (e.g., inspection process) using the beam grid 102. The subsequent processing of the sample 208 may comprise inspecting the sample 208 for defects for example. The generated sample surface topographical map may be used to control positioning of the sample 208 during the subsequent processing. For example, in the situation shown in **FIG. 9** the sample 208 may be positioned higher up, such that the portion of the sample surface in the path 103 of the beam grid 102 is within the range of positions defined by the upper limit 110 and the lower limit 112 rather than outside of this range. Alternatively or additionally, the control system 500 may control positioning of the focal plane for each of one or more of the charged particle beams of the at least a portion of the beam grid 102. The position of the focal plane 108 may be defined by potentials applied to electrodes in the charged particle device, such as electrodes of the objective lens array 401 and/or control lens array 250, as described above with reference to FIG. 2-7. The control system 500 may thus adjust the position of the focal plane for each of one or more of the charged particle beams by changing potentials applied to appropriate electrodes in the charged particle device. This may be achieved via macro electrodes that operate on all charged particle beams, such that the focal plane is adjusted in the same way for all beams. Alternatively or additionally, electrodes may be configured to operate independently on different beams or groups of beams. For example, strip electrodes, such as an array of strip electrodes, may be provided that operate on groups of beams. The groups of beams may be arranged in lines, for example in parallel lines, of beams of the beam grid. The strip electrodes of a stack of such arrays of strip electrodes positioned along the path of the beam grid may have different relative orientations across the beam grid for example along the primary axes of the beam grid which may for example be rectilinear or hexagonal. Although the beams are operated on by each array of strip electrodes as part of a group, such as a line of beams, a number of strip electrodes of the stack together may be configured such that the beams are members of different groups of beams (e.g. lines) of the beam grid at different arrays of strip electrodes. Thus different beams of the beam grid may be operated on differently by a number of the stack of arrays of strip electrodes (such as the whole stack of arrays of strip electrodes) from another beam of the beam grid. That is, a stack of arrays of strip electrodes may be capable of selectively applying different deflections to different beams of the beam grid.

In embodiments having proximity sensors 104, the control system 500 may use the generated sample surface topographical map together with output data from the proximity sensors 104 to control the positioning of the sample and/or focal planes during the subsequent processing (e.g., inspection) of the sample 208. Using such a combination of information may provide improved robustness/reliability and/or allow for control with greater granularity. For example, information obtained from the proximity sensors 104 may be used to verify and/or adjust information about sample surface topography provided by the generated sample surface topographical map. The sample surface topography may drift, for example, due to changes in temperature within the sample 208 in a period between performing the scanning to generate the sample surface topographical map and the subsequent processing of the sample 208. Measurements from the proximity sensors 104 may be used to update the generated sample surface topographical map or to apply corrections to compensate for errors in the generated sample surface topographical map.

In some embodiments, the control system 500 is configured to select a common focal plane for the charged particle beams. This may be done relative to a part of the sample surface, for example during calibration relative to an idealized sample surface which may have a low variation of surface position (e.g., along the direction of the grid path) across the surface. The common focal plane is the same for at least a portion of the charged particle beams, optionally for all of the charged particle beams. This approach reduces or avoids having to control focal planes individually for each of the charged particle beams, for example by operating an electron-optical element such as a lensing element along the respective beam path. For example, in an embodiment adjusting the focus of a charged particle beam (such as relative to the average focal plane of the beam grid) may be done only periodically, such as at the start of processing of a sample, or a lot of samples or even only at servicing of the assessment apparatus. Such adjusting of the focus of a charged particle beam may not be dynamic; such adjusting may be referred to as calibration of the charged particle beam and of the beam grid. Infrequent adjustment, e.g. non-dynamic control, of the focal planes of the beam grid may be desirable because it facilitates simplicity of the design of the charged particle device. That is, the charged particle device can omit having an array of individual beam correctors or any other type of corrector array. Introducing such an electron-optical component in a charged particle device may add complexity, for example if the beam grid has many beams, for example more than a hundred beams, for example thousands of beams, where each individual corrector requires at least one control signal. Such a beam grid may have a large field of view.

In an embodiment, a calibration of the common focal plane may be performed by adjusting focal planes of the charged particle beams to statistically minimize differences between focal planes (or focus positions or foci) of the charged particle beams within the beam grid relative to an ideal focal plane (e.g., in which the different beams of the beam grid have a focus at the same position along the path of the beam grid). The control system 500 may be selected to cause subsequent processing of the sample 208, or subsequent samples processed by the beam grid, to be performed with at least a portion of the beam grid 102, e.g. a selection of the beams of the beam grid, focused at the calibrated common focal plane. In an embodiment, beams that have a focal plane further from the calibrated common focal plane than a focus threshold may be removed from the selection of beams of the beam grid. Such subsequent samples may be processed after the sample 208 that is used to calibrate the common focal plane of the beam grid: at set up, or periodically, for example during servicing, after a set time period, time of sample processing or after processing a set number of samples. Such calibration may be periodic after a period of elapsed time and/or after processing a certain number of samples to account for expected drift in the behaviour and performance of the charged particle device, desirably to ensure stability. For assessment systems in which calibration is required periodically , the knowledge of the common focal plane may assist in determining the sample position by controlling the positioning of the sample along the beam grid path for the different focus condition settings for each target portion 114... When a calibrating the common focal plane, the sample surface may be of a dedicated reference sample specifically used for calibration, a special surface of the stage such as a sample kit having surface characteristics similar to a sample, or a sample which may be processed such as for assessment e.g. inspection.

In an embodiment, the control system 500 uses the generated sample surface topographical map to select a common focal plane for the beam grid 102. The common focal plane may be selected such that the common focal plane is improved or optimal. The common focal plane may have small differences or perturbations from the focus of each beam of the beam grid. Such differences or perturbations may have a small desirably negligible effect on the common focal plane. The selected common focal plane may be selected to maximize an average quality of focus of the charged particle beams on the sample surface (averaged over the charged particle beams in the beam grid 102). For example the selected common focal plane for a specific sample may be selected to minimize a sum of differences between positions of the processed target regions 114 (e.g., as provided by the generated sample surface topographical map) and the common focal plane, for example by using a least squares method or similar. The control system 500 causes the subsequent processing of the sample 208 by the beam grid 102 to be performed with at least a portion of the beam focused at the common focal plane.

In some embodiments, the control system uses the generated sample surface topographical map to select a grid path position of the sample along the path of the beam grid. In an embodiment the grid path position may be referred to as a Z position or Z level by reference to a Cartesian coordinate system with the Z axis aligned with a principal axis of the path 103 of the beam grid 102. The grid path position may be defined with respect to the principal axes of the paths of the beams of the beam grid 102. In another arrangement the grid path position may be defined by the principal axis of the net or average path of the beam grid 102, e.g. with respect to the average of the paths of the different beams of the beam grid. Where the beam grid has a relatively large field of view, e.g. more than about 0.5mm, for example in the range of 0.5 to 30 mm or 1 to 30 mm such as 0.5 to 15 mm, for example relative to the probe size (cross-sectional area) of each beam and/or the surface area of the sample surface, the grid path position may additionally have a tilt component (or comprise a parameter of tilt) relative to the Z axis aligned with a principal axis of the path 103 of the beam grid 102. The selected grid path position may be selected such that the grid path position is improved or optimal. The selected grid path position may, for example, be selected to minimize the displacement along the principal axis of the path 103 of the beam grid of the focal plane relative to the sample surface. The grid path position may, for example, be selected to maximize an average quality of focus of the charged particle beams on the sample surface (e.g., averaged over the charged particle beams in the beam grid 102). The selected grid path position may be selected to minimize a sum of differences between Z positions of the processed target regions 114 and a focal plane of the beam grid, for example by using a least squares method or similar. The control system 500 causes the subsequent processing of the sample 208 by the beam grid to be performed with the sample positioned at the selected grid path position. In arrangement in which the focal plane of the beams of the beam grid are static, the grid path position may be determined for a sample, or even for different regions of the same sample, for example in an assessment apparatus in which the field of view of the beam grid at the grid path position is smaller, for example a fraction of the area of the sample surface.

Example approaches for how to use the detection signals from the detector to generate the sample surface topographical map are now described.

In some embodiments, the control system 500 controls the sample support, the detector and/or the charged particle device to perform the scanning of at least a subset of the beam grid 102 and respective target portions 114 relative to each other at a plurality of different focus condition settings of the assessment apparatus. Each focus condition setting may define a different relative position between the focal plane 108 and the respective target portion 114 for each charged particle beam. Each focus condition setting may thus vary a quality of the focus on each target portion 114. The scanning of the at least a subset of the beam grid 102 and respective target portions 114 relative to each other at the plurality of focus condition settings may comprise each charged particle beam processing all of the target portion 114 corresponding to that charged particle beam once at each of the plurality of focus condition settings. Thus, the same target portion 114 on the sample 208 is processed by a charged particle beam multiple times, each time with a different focus condition setting. Each target portion 114 may be processed with the focus condition settings in sequence (i.e., in series), one focus condition setting at a time. The detector may be configured to detect signal charged particles independently for each target portion 114, such that images of multiple target portions 114 can be generated at the same time.

The different focus condition settings for each target portion 114 may be provided by controlling the positioning of the sample, controlling the positioning of focal plane of the respective charged particle beam, or both.

For example, in some embodiments the control system 500 provides the plurality of different focus condition settings by controlling the positioning of the sample support in at least one degree of freedom with respect to the charged particle device. The at least one degree of freedom may comprise a position of the sample support along the path 103 of the beam grid 102 and/or an orientation of the sample support such as tilt (rotation about an axis) relative to a direction orthogonal to the path 103 of the beam grid 102.

**FIG.** 11 schematically depicts four charged particle beams 121-124 of a beam grid 102 having a common focal plane 108 (the position of the focal plane 108 is the same in this example for all of the beams 121-124). Three example positions of a portion of the sample 208 are shown, labelled respectively 208', 208", and 208"'. Each position corresponds to a different example focus condition setting, implemented in this case by positioning the sample at a different respective Z position. The portion of the sample in the path of the beam grid 102 is tilted relative to an orthogonal of a principal axis of the beam grid 102. Position 208' is furthest from the detector module 402 along the path of principal axis and position 208'" is closest to the detector module 402. The sample 208 may be positioned relative to the path of the beam grid 102 by reference to a point, for example a reference point, on the sample surface along the path of the beam grid, e.g. which may correspond to the principal axis of the beam grid. The portions of the sample 208 are sloped (or tilted) to represent unflatness of the sample surface.

In this simplified example, it can be seen that when the focus condition setting is such that the sample 208 is at position 208' the rightmost beam 124 is well focused on the target portion 114 of sample surface corresponding to beam 124. A target portion 114 processed by beam 124 at this focus condition setting (i.e., with the sample 208 is at position 208') would produce an image with properties indicating a high quality of focus (e.g., high contrast). In contrast, target portions 114 processed by beams 123, 122 and 121 would produce images with progressively decreasing qualities of focus (e.g., progressively lower contrast). This information suggests that the topography of the sample surface slopes either up or down along a line through the target portions 114 corresponding to beams 121-124 (for example a line passing through points defined by intersections between the sample and paths of the respective beams 121-124 through the target portions 114). When the focus condition setting is such that the sample 208 is at position 208" the leftmost beam 121 is well focused on the target portion 114 of sample surface corresponding to beam 121. A target portion 114 processed by beam 121 at this focus condition setting (i.e., with the sample 208 is at position 208") would produce an image with properties indicating a high quality of focus (e.g., high contrast). In contrast, target portions 114 processed by beams 122, 123 and 124 would produce images with progressively decreasing qualities of focus (e.g., progressively lower contrast).

The information from the two different focus condition settings confirms the presence of a slope and also provides the direction (or sign) of the slope. In this case, the slope must ascend from left to right. The third focus condition setting shown, with the sample 208 at position 208‴ may be used to refine or confirm the measurement of the topography of the sample surface. In this case all of the target portions 114 processed by the beams 121-124 will be out of focus but the extent of defocus still varies between the different target portions 114. If the variation in focus quality is detectable, for example as a measurable difference in contrast in images derived from the respective target regions 114, then information about the topography of the sample surface may be obtained.

Alternatively or additionally, in some embodiments the control system 500 provides the plurality of different focus condition settings by controlling the positioning of the focal plane of each charged particle beam of the at least a subset of the beam grid 102 relative to the charged particle device.

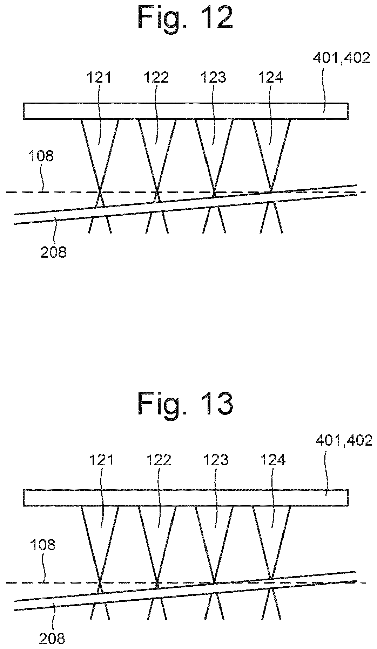

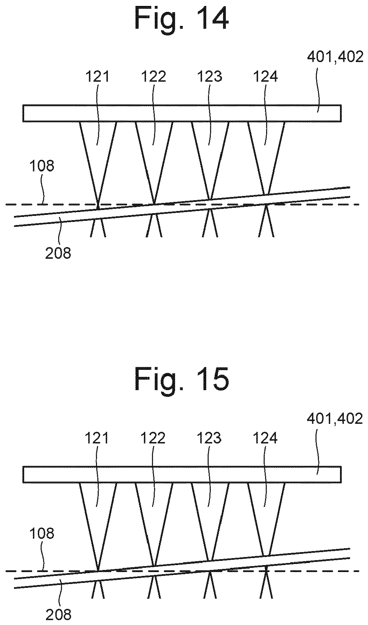

**FIG. 12-15** schematically depict how focal planes 108 of the same four charged particle beams 121-124 of **FIG. 11** can be changed to provide different focus condition settings. In this case, each different position of the focal plane 108 corresponds to a different respective focus condition setting. The focal plane 108 is closest to the charged particle device in **FIG. 12** and is moved progressively further away in **FIG. 13-15** for example at different positions relative to the charged particle device 41 and the sample 208 along the path of the beam grid 102; the focal plane 108 being furthest from the charged particle device in **FIG. 15****.** The sample 208 is at the same position and orientation relative to the charged particle device for all of the four focus condition settings depicted in **FIG. 12-15****.** As described for the arrangement of **FIG. 11****,** the portion of the sample 208 shown is sloped to represent unflatness. In this example, it can be seen that when the focus condition setting of **FIG. 12** is applied, the rightmost beam 124 is the best focused on the sample surface and beams 123, 122, and 121 are progressively less well focused. When the focus condition setting of **FIG. 13** is applied, beam 123 is the best focused, beams 122 and 124 are less well focused, and beam 121 is the least well focused. When the focus condition setting of **FIG. 14** is applied, beam 122 is the best focused, beams 121 and 123 are less well focused, and beam 124 is the least well focused. When the focus condition setting of **FIG. 15** is applied, the leftmost beam 121 is the best focused and beams 122, 123, and 124 are progressively less well focused.

In this example, each focus condition setting causes a different one of the beams 121-124 to be optimally focused on the sample surface. The optimal focusing can be detected as described above by assessing images derived from processed target portions 114. The image derived from the beam at optimal focus may have the best contrast for example. If the distance of the focal plane 108 from the charged particle device, for example along the path of the beam grid, such as the principal axis of the beam grid, is known at each focus condition setting, this approach allows the topography of the sample surface, or at least a part of the sample surface, to be mapped. In the example of **FIG. 12-15****,** it is possible to obtain values for the Z positions of the target portions 114 corresponding to each of the four beams 121-124, for example relative to the principal axis of the path of the beam grid. The Z position of each target portion 114 can be derived from the position of the focal plane 108 that provides the highest quality focus for the beam corresponding to the target portion 114.

Two different approaches to varying focus condition settings for determining the topographical map of the sample are described above. In arrangements described with reference to FIG. 11, different focus condition settings are achieved by moving the sample. In arrangements described with reference to FIG. 12 to 15, different focus condition settings are achieved by moving focal planes of the beam grid such as relative to a sample. These two approaches may be used as alternatives. In a different embodiment, the different approaches are complementary and may be used in combination.

The analyzing of the detection signals from the detector may comprise calculating a metric representing a quality of focus during the processing of each target portion 114 at each focus condition setting. In some embodiments, an image of the target portion 114 is derived from the detection signals (e.g., using an image acquirer as described above). In such a case, the metric may comprise a representation of the quality of focus derived from the image. For example, the metric may comprise a contrast level. The contrast level may be calculated by comparing intensities in different regions of the derived image, for example between regions that are relatively dark (low intensity) and regions that are relative light (high intensity). The metric may comprise a measure of an edge sharpness, such as measure of a maximum rate of change of intensity in the image as a function of a position along a path that passes through a boundary between a relatively dark feature and a relatively light feature, for example adjoining regions defined by different pixels or groups of pixels of the image.

In some embodiments, the control system 500 generates the sample topographical map by identifying an optimal focus condition setting from the plurality of different focus condition settings for each processed target portion 114 of the sample surface. Identifying the optimal focus condition settings for the different target portions 114 identifies positions of the focal plane and/or sample 208 where the focal plane and sample surface coincide most closely, thereby providing information about the topography of the sample surface.

In some embodiments, the control system 500 is configured to import an externally-derived topographical map. The externally derived topographical map may be treated as data associated with the sample as the sample is transferred between systems and between processes. The externally derived topographical map be data that is part of a sample data set, such as metadata of the sample. The externally-derived topographical map represents a topography of the sample surface measured using an external device. The external device does not form part of the assessment apparatus. The external device may comprise an optical assessment device (or apparatus) or a lithography device (or apparatus). Alternatively or additionally, the assessment apparatus may comprise an optical measurement system configured to measure a topographical map of at least part of the sample surface. The measured topographical map represents a topography of the sample surface. Alternatively or additionally, the control system 500 may be configured to receive a sample support topographical map representing a topography of the sample support. The control system 500 may use the externally-derived topographical map and/or the measured topographical map and/or the sample support topographical map to select the subset of the charged particle beams. As described above, for example, the subset may be selected to avoid regions on the sample surface that are damaged or which have local topography which departs excessively from an average topography, for example a region of the sample surface which has a surface displacement away from a net plane of the sample surface which exceeds a threshold such as a focus threshold. Alternatively or additionally, the externally-derived topographical map and/or the measured topographical map and/or the sample support topographical map may be used to select one or more of the focus condition settings used during the generation of the sample topographical map. For example, the externally-derived topographical map and/or the measured topographical map and/or the sample support topographical map may be used to provide a coarse topographical map that indicates roughly where the sample surface is expected to be and the focus condition settings are selected to allow fine tuning. The selected focus condition settings may be such as to provide multiple positions of the focal plane relative to the expected position of the sample surface in each target region 114 within a small range to allow the fine tuning without excessively reducing throughput. As described above, this may be achieved by adjusting the sample position with respect to the charged particle device 102 such as with respect to (e.g. along) the grid path, for example using the actuated stage 209, and/or by controlling the focal plane of the beam grid, for example by adjusting the focal plane for all beams of the beam grid, for example by adjusting a common focal plane, and/or by controlling the individual focus of beams of the beam grid.

In some embodiments, the control system 500 uses the externally-derived topographical map in combination with output data from the proximity sensors 104 to process the sample 208. The control system 500 may, for example, process the sample 208 using the beam grid 102 while controlling a positioning of the sample 208 using the externally-derived topographical map and the output data from the proximity sensors 104. This approach may be performed with or without generating a sample surface topographical map by scanning the target portions 114 as described above. The output data from the proximity sensors may be used to determine the position of the sample relative to the path of the beam grid 102 by reference to the externally-derived topographical map. Since the output data of the proximity sensors comprises measurement information of the sample relative to the path of the beam grid, and is therefore a measurement of the sample position, the output data may be used to determine the position of the sample surface relative to the beam grid and also correct any errors (or differences) in the position of a portion of the sample relative to the path of the beam grid determined by the externally-derived topographical map based on the output information from the proximity sensors.

In some embodiments, the control system 500 receives a sample support topographical map. The sample support topographical map represents a topography of the sample support. The sample support topographical map may be measured by an external device or by the assessment apparatus. In the latter case, the sample support topographical map may be generated by measuring the sample support topography directly, without a sample 208 in position on the sample support, desirably before the sample support supports the sample 208. This measurement may be performed using the proximity sensors 104 and/or the beam grid and/or a measured topographical map using the optical measurement system. Alternatively, a sample surface topographical map may be generated for multiple different samples and/or for multiple different sample rotations such that the contribution to the topography of the sample surface facing the charged particle device from the sample itself can be subtracted or averaged out, thereby allowing the contribution to the topography of the sample surface from the sample support to be derived. The control system 500 may use the sample support topological map as calibration to generate the sample surface topological map. In an embodiment, a position in the sample support topological map is fed forward for the determining of a same position in the sample surface topological map. The control system may control the sample support based on the position in the sample support topological map to process a respective target position at the same position in the sample surface topological map.

The topography of the sample support may comprise a topography of a surface of the sample support that contacts the sample 208 when the sample 208 is supported by the sample support. The topography of the sample support may thus contribute to the topography of the sample surface facing the beam grid 102. The topography of the sample surface facing the beam grid 102 may be determined by a combination of the topography of the sample 208 and the topography of the sample support. The sample support topographical map (whether received such as from a device external to the assessment apparatus, or measured such as within the assessment apparatus) may thus be used to calibrate a sample surface topographical map, such that the sample surface topographical map provides a more accurate estimate of the topography of the sample surface facing the beam grid 102. Such more accurate estimate of the topography of the sample surface enables improvement in the control of focus of the beam grid 102. Thus, the sample surface topographical map may be calibrated with the sample support topological map to generate a calibrated topographical map and the positioning of the sample position controlled using the calibrated topographical map. This approach may be performed with or without generating a sample surface topographical map by scanning the target portions 114 as described above.

In some embodiments, a position in the sample support topographical map (whether received by or generated in the assessment apparatus) is fed forward for the determining of a same position in the sample surface topographical map. The control system 500 may control the positioning of the sample support, for example the sample relative to the path of the beam grid, to process a respective target portion 114 of the sample surface that is at the same position in the sample surface topographical map as in the sample support topographical map. So in processing the respective target portion 114 the control system 500 may control the positioning of the sample support based on the same position in the sample support topographical map as in the sample surface topographical map, that is of the respective target portion 114.

In some embodiments, the control system 500 may receive the sample support topographical map as described above. In this case, the control system 500 may control a positioning of the sample 208 during the processing of the sample 208 additionally using the sample support topographical map. As described above, the generated sample surface topographical map may be calibrated using the sample support topographical map to generate a calibrated topographical map. The positioning of the sample may then be controlled using the calibrated topographical map.

In some embodiments, the control system 500 receives the sample support topographical map as described above and the control system uses the received sample support topographical map in combination with output data from the proximity sensors 104 to process the sample 208. The control system 500 may, for example, process the sample 208 using the beam grid 102 while controlling a positioning of the sample 208 using the received sample support topographical map and the output data from the proximity sensors 104. This approach may be performed with or without generating a sample topographical map by scanning the target portions 114 as described above. The positioning of the sample may be achieved using the output data from the proximity sensors 104 to determine the position of the sample within the sample support topographical map. The positioning of the sample may be achieved by using the output data from the proximity sensors 104 to calibrate, correct and/or optimize the position of the sample determined by reference to the sample support topographical map.

In some embodiments, the control system 500 comprises an optical measurement system configured to measure a topographical map representing a topography of the sample surface. The optical measurement system may comprises one or more light sources operable at one or more wavelengths of light configured to direct respectively a beam over the sample surface for detection by one or more sensors. The one or more sensors may be configured to detect light from the one or more light sources reflected from the sample surface. The optical measurement system may have a linear array comprising the one or more light sources and one or more detectors. The linear array may desirably be dimensioned to extend across a maximum dimension of a sample, desirably in a sensing direction. In an embodiment, the light source and array of sensing elements are configured relative to the sample support such that when the sample is moved relative to the linear array in a scanning direction, desirably angled relative to the sensing direction, the optical measurement system processes the sample surface, desirably the entire sample surface. The apparatus may additionally comprise a detector configured to detect signal charged particles emitted from the sample and provide an output.

The optical measurement system may operate to measure the sample surface by moving the sample surface and the linear array relative to each other. A topographical map may then be generated. During measurement of the sample surface using the optical measurement system, the sample may be on the sample support such in moving between an unload position (e.g. on placing the sample on the sample support) and an assessment position in the path of the beam grid. The control system 500 may use the measured topographical map to control a positioning of the sample 208 during processing of the sample 208 by the beam grid. This approach may be performed with or without generating a sample topographical map by scanning the target portions 114 with the beam grid 102 as described above. The map derived from the optical measurement system may generate a coarse map for example of the entire sample surface or at least one or more selected regions. Another measurement system such as for measurement using the beam grid may be used for generating a surface map of finer resolution than the coarse map of a part of the sample surface (even the entire sample surface) or a part of a selected region. Alternatively or additionally, a coarse map of a part or all of the sample surface may be obtained by measuring a variation of a size of a gap above the sample surface by measuring a corresponding variation in air pressure. In an embodiment, the course map is defined relative to points that are spaced apart by a distance in the range of about 2 to 20mm, for example about 10mm. The finer resolution surface map may determine surface map information for every beam and thus have a spatial resolution comparable to a pitch between beams. The spatial resolution may thus be in the range of about 50 to 200 microns. In embodiments where the surface map information is only obtained for a subset of the beams the spatial resolution may be lower. For example, if 25% of the beams are used the pitch will double. The spatial resolution in this case may be in the range of about 100 to 400 microns. The number of beams to use to determine the topographical map may be selected based on the accuracy that is required for the use case being considered.

In embodiments having proximity sensors 104, the control system 500 may be configured to use the proximity sensors 104 to generate a sample surface topographical map. For example, the control system 500 may generate the sample surface topographical map by controlling the sample support to move the sample 208 through a range of positions and/or orientations relative to the charged particle device while using the proximity sensors 104 to measure respective changes in distances between the proximity sensors 104 and the sample surface. Where a principal axis of the beam grid 102 is the Z axis, for example of a Cartesian coordinate system, the movement of the sample 208 in this case may involve movements predominantly in the plane orthogonal to the Z axis, for example in an X-Y plane, such that the proximity sensors 104 can be scanned relatively to, for example over, a large proportion or all of the sample surface facing the charged particle device. The generated sample surface topographical map may be used to control the position and/or orientation of the sample 208 during processing of the sample 208 by the beam grid 102. The generated sample surface topographical map may be used to correct setpoints defining the position of the sample 208 with respect to output data from the proximity sensors 104. The orientation may be the tilt of the sample such as the rotational displacement of the sample surface away from the plane orthogonal to the beam path of the beam grid (e.g. the primary axis of the beam grid), desirably about an axis in the orthogonal plane. The position and/or orientation of the sample 208 may be controlled to move through a continuous range of different positions and/or orientations during the processing by the beam grid.

Although several different ways are described herein to generate a sample topographical map, the different techniques may be used individually or in combination. Selection of a technique or a combination of techniques may be dependent on the desired characteristics of the sample topographical map for the intended application. For example, where maximum coverage of the sample surface is required, a technique or combination of techniques would be selected which provides a useful map despite having coarser resolution and/ or while being dependent on correction or calibration, such as where the sample topographical map is dependent on an externally imported sample map or generation from an optical measurement system. Combining with a technique capable of providing fine resolution for at least parts of the sample surface requiring a fine resolution enables the required accuracy in the sample topographical map to be achieved without, or with reduced, impact on throughput. Further, accounting for the sample support topographical map enables improved application of externally generated sample maps of the sample and improves the applicability of data about the sample surface such as the sample surface topographical map for later processing of the sample in a different apparatus.

Sample unflatness can in some cases be so extreme that some areas on the sample, or indeed the whole sample, may not be safely processable by the charged particle device. This may arise due to the presence of particles between the sample and the sample support (backside defectivity) or via other defect mechanisms or extreme sample and/or sample table topographies. In an embodiment the stress applied to the sample by earlier processing, for example in defining three dimensional structures of the sample surface, may cause the sample to bow or bend out of the plane of an ideal sample. One or more regions of the sample rim may be curved upward. To allow for this situation, a sample surface topographical map may be obtained (using any of the methods described above or other methods) and regions on the sample surface topographical map may be annotated to provide information about the suitability of the regions to undergo an inspection process by the beam grid. Different surface portions of the sample surface may be classified depending on the surface placement relative to the sample support and/or the slope or tilt of the surface portion. For example, a first subset of the regions may be annotated as being fully suitable for inspection; a second subset of the regions may be annotated as being partially suitable for inspection (or suitable if precautionary measures are taken); and a third subset of the regions may be annotated as being not suitable for inspection. The first subset of regions or class of regions may thus comprise regions in which the sample topography is relatively flat or the displacement variations of the sample surface are within a first threshold, such that it is possible to control the positioning of the sample 208 and/or focal plane to achieve an acceptable quality of focus in substantially the whole of each region in the first subset of regions. The second subset of regions, or second class of regions, may comprise regions in which the sample topography is more challenging but not so severe that processing by the beam grid would be impossible, at least for portions of the regions in the second subset. The second class of regions have a sample surface with displacement variations that are at or exceed a first threshold and are within a second threshold. The third subset of regions, or a third class of regions, may comprise regions in which the sample topography is too severe for processing by the beam grid to be useful and/or safe. The third class may comprises a surface portion with displacement variations that are at or exceed a second threshold.

The annotated sample surface topographical map (or a classified surface map) may be used in various ways. In one approach, the assessment apparatus may selectively inspect only regions of the sample that are annotated to be in the first subset, or only regions that are annotated to be in the first subset or the second subset. This may be achieved by using only a portion of the beam grid (i.e., only a subset of the charged particle beams available) to process the sample 208. The particular subset of charged particle beams to use may vary as the intersection of the beam grid with the different regions of the sample varies, such that only the selected regions (in the first and/or second subsets) are processed. Alternatively, all of the charged particle beams in the beam grid are used and data corresponding to regions that are not to be selected (in the second and/or third subsets) may be discarded. In several use cases it is not necessary to inspect the whole sample. For example, in reticle mask inspection it is normally not necessary to inspect the whole substrate. A subset of the dies may be sufficient. Inspection of regions near edges of the sample may provide particularly useful information and the annotated sample surface topographical map allows areas that are flat enough to inspect efficiently to be identified quickly and easily.

In another approach, when a region of interest is to be processed by a portion of the beam grid that will not be in good focus (due to difficult topography, as indicated in the annotated sample surface topographical map), the region of interest may be processed multiple times at different focus condition settings. As related in the description above, the different focus condition settings may include different sample positions and/or different focal plane positions. (The sample position may be the position of the sample surface with respect to the grid beam path, desirably a position of the sample surface across the grid beam path. The focal plane position may be the position of a plane common to the focal points of the beam grid or at least selected beams of the beam grid). The data obtained in this way may be merged to provide improved focus over the whole field of view. Regions that are in poor focus at some focus condition settings may be in better focus at other focus condition settings and vice versa. Merging the data obtained from processing the region of interest multiple times makes it possible to select the best version of each sub-region. For example, an image of each sub-region that has the best focus (e.g., highest contrast) may be selected from the multiple images of that sub-region provided by processing the region of interest at the multiple focus condition settings.

In some arrangements, sub-regions in a region of interest may be processed multiple times by different charged particle beams of the beam grid. For example, processing of the sample by the beam grid may be repeated multiple times with the beam grid displaced by one or more beam pitches. Best quality images of the sub-regions may be selected and stitched together to provide an overall image having better quality that would be possible using only a single scan of each sub-region. This approach compensates for variations in the position of the focal plane between different charged particle beams in the beam grid at the expense of lower throughput.

All data generated related to a sample, for example the properties of the sample surface such as a coarse map and/or a fine map of the sample surface, whether for the entire sample surface or a portion of the sample surface, may be added to the sample data set. The generated data related to the sample may be added to the sample data set as the sample is processed. The sample may be transferred to further fabrication processes with a sample data set. The exported sample data set may well be larger than when the sample was introduced to the assessment apparatus.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 241, and the detector array 240.

References to upper and lower, up and down, above and below, etc. should be understood as referring to directions parallel to the (typically but not always vertical) up-beam and down-beam directions of charged particle beams impinging on the sample 208. Thus, references to up beam and down beam are intended to refer to directions in respect of the beam path independently of any present gravitational field.

Electron-optics described herein may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electromagnetic field of the compound lens array.

An assessment apparatus, tool or system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment apparatus, tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses:
Clause 1. An assessment apparatus for assessing a sample using a plurality of charged particle beams, comprising: a sample support configured to support a sample, the sample having a sample surface; a charged particle device configured to project a beam grid of a plurality of charged particle beams along a grid path of the beam grid towards the sample; a detector configured to detect signal charged particles from the sample and generate detection signals on detection of the signal charged particles; and a control system configured to: control the sample support, the charged particle device and/or the detector to: scan at least a subset of the beam grid and respective target portions of the sample surface relative to each other, so as to process the target portions; and generate a sample surface topographical map representing a topography of the sample surface by analyzing detection signals detected in response to the scan of the at least a subset of the beam grid and respective target portions relative to each other.
Clause 2. The apparatus of clause 1, wherein the control system is configured to control the sample support, the charged particle device and/or the detector to perform the scan of the at least a subset of the beam grid and respective target portions relative to each other at a plurality of focus condition settings of the apparatus.
Clause 3. The apparatus of clause 2, wherein each focus condition setting defines a relative position between the focal plane and the respective target portion for each charged particle beam of the at least a subset of the beam grid.
Clause 4. The apparatus of clause 2 or 3, wherein the scan of the at least a subset of the beam grid and respective target portions relative to each other at the plurality of focus condition settings comprises each charged particle beam of the at least a subset of the beam grid processing all of the target portion corresponding to that charged particle beam once at each of the plurality of focus condition settings.
Clause 5. The apparatus of any of clauses 2 to 4, wherein the control system is configured to implement the plurality of focus condition settings by controlling the positioning of the sample support in at least one degree of freedom with respect to the charged particle device, desirably the at least one degree of freedom comprising: a position of the sample support along the grid path; and/or an orientation of the sample support, desirably tilt relative to a direction orthogonal to the grid path.
Clause 6. The apparatus of any of clauses 2 to 5, wherein the control system is configured to implement the plurality of focus condition settings by controlling the positioning of a focal plane of each charged particle beam of the at least a subset of the beam grid relative to the charged particle device.
Clause 7. The apparatus of any of clauses 2 to 6, wherein the control system is configured such that the analyzing of detection signals comprises calculating a metric representing a quality of focus during the processing of each target portion at each focus condition setting.
Clause 8. The apparatus of clause 7, wherein the metric comprises a contrast level in an image of the target portion derived from the detection signals.
Clause 9. The apparatus of any of clauses 2 to 8, wherein the control system is configured to generate the sample surface topographical map by identifying an optimal focus condition setting from the plurality of different focus condition settings for each target portion of the sample surface processed by the scan of the at least a subset of the beam grid and respective target portions of the sample surface relative to each other.
Clause 10. The apparatus of any of clauses 2 to 9, wherein the control system is configured to import an externally-derived topographical map representing a topography of the sample surface measured using an external device and to use the externally-derived topographical map to select one or more of the different focus condition settings.
Clause 11. The apparatus of any of clauses 2 to 10, wherein: the apparatus comprises an optical measurement system configured to measure a topographical map representing a topography of the sample surface; and the control system is configured to use the measured topographical map to select one or more of the different focus condition settings.
Clause 12. The apparatus of any of clauses 2 to 11, wherein the control system is further configured to receive a sample support topographical map representing a topography of the sample support and to use the sample support topographical map to select one or more of the different focus condition settings.
Clause 13. The apparatus of any preceding clause, wherein the control system is configured to use the generated sample surface topographical map during a subsequent processing of the sample using at least a portion of the beam grid, to: control positioning of the sample during the subsequent processing; and/or control positioning of the focal plane for each of one or more of the charged particle beams of the at least a portion of the beam grid during the subsequent processing.
Clause 14. The apparatus of any preceding clause, wherein the charged particle device comprises a plurality of proximity sensors configured to face the sample, each proximity sensor configured to measure a distance between the proximity sensor and the sample, desirably the proximity sensors being capacitive sensors, desirably differential capacitive sensors.
Clause 15. The apparatus of clause 14, wherein the control system is configured to use the generated sample surface topographical map and output data from the one or more proximity sensors during a subsequent processing of the sample using at least a portion of the beam grid, desirably to: control positioning of the sample during the subsequent processing; and/or control positioning of the focal plane for each of one or more of the charged particle beams of the at least a portion of the beam grid during the subsequent processing.
Clause 16. The apparatus of any preceding clause, wherein the control system is configured to use the generated sample surface topographical map to select a grid path position of the sample along the grid path, desirably an optimal grid path position, and to perform a subsequent processing of the sample by the beam grid with the sample positioned at the grid path position.
Clause 17. The apparatus of any preceding clause, wherein the control system is configured to use the generated sample surface topographical map to select a common focal plane, desirably an optimal common focal plane, for the beam grid and to perform a subsequent processing of the sample by the beam grid with at least a portion of the beam grid focused at the common focal plane.
Clause 18. The apparatus of any preceding clause, wherein the control system is configured to select the subset of the beam grid: with reference to a predetermined topographical map of the sample surface; as a contiguous portion of the beam grid; and/or as a distribution of groups of one or more charged particle beams, each group separated from the other groups by one or more charged particle beams outside of the subset.
Clause 19. The apparatus of any preceding clause, wherein the control system is configured to import an externally-derived topographical map representing a topography of the sample surface measured using an external device and to use the externally-derived topographical map to select the subset of the beam grid.
Clause 20. The apparatus of any preceding clause, wherein: the apparatus comprises an optical measurement system configured to measure a topographical map representing a topography of the sample surface; and the control system is configured to use the measured topographical map to select the subset of the beam grid.
Clause 21. The apparatus of any preceding clause, wherein the control system is further configured to receive or generate a sample support topographical map representing a topography of the sample support and to use the received or generated sample support topographical map to calibrate the generated sample surface topographical map.
Clause 22. The apparatus of clause 21, wherein the control system is configured to generate the sample support topological map without a sample on the sample support, desirably before the sample support supports the sample.
Clause 23.The apparatus of clause 21 or 22, wherein the control system is configured to use the sample support topological map as calibration to generate the sample surface topological map.
Clause 24. The apparatus of clause 23, wherein a position in the sample support topological map is fed forward for the determining of a same position in the sample surface topological map, desirably the control system is configured to control the sample support based on the position in the sample support topological map to process a respective target position at the same position in the sample surface topological map.
Clause 25. The apparatus of any preceding clause, comprising: an objective lens array desirably proximate the sample; and a detector desirably proximate the sample and desirably comprised in the objective lens array.
Clause 26. An assessment apparatus for assessing a sample using a plurality of charged particle beams, comprising: a sample support configured to support the sample, the sample having a sample surface; a charged particle device configured to project a beam grid of a plurality of charged particle beams along a grid path of the beam grid towards the sample; a plurality of proximity sensors configured to face the sample, each proximity sensor configured to measure a distance between the proximity sensor and the sample and provide output data; and a control system configured to: import an externally-derived topographical map representing a topography of the sample surface measured using an external device; and process the sample using the beam grid while controlling a positioning of the sample using the externally-derived topographical map and the output data from the plurality of proximity sensors.
Clause 27. The apparatus of clause 26, wherein the control system is configured to: receive a sample support topographical map representing a topography of a surface of the sample support; and control a positioning of the sample during the processing of the sample additionally using the sample support topographical map, desirably by calibrating the externally-derived topographical map with the sample support topographical map to generate a calibrated topographical map and controlling the positioning of the sample using the calibrated topographical map.
Clause 28. An assessment apparatus for assessing a sample using a plurality of charged particle beams, comprising: a sample support configured to support a sample, the sample having a sample surface; a charged particle device configured to project a beam grid of a plurality of charged particle beams along a grid path of the beam grid towards the sample; a plurality of proximity sensors configured to face the sample, each proximity sensor configured to measure a distance between the proximity sensor and the sample and provide output data; and a control system configured to: receive a sample support topographical map representing a topography of a surface of the sample support; and process the sample using the beam grid while controlling a positioning of the sample using the sample support topographical map and the output data from the plurality of proximity sensors.
Clause 29. An assessment apparatus for assessing a sample using a plurality of charged particle beams, comprising: a sample support configured to support a sample, the sample having a sample surface; a charged particle device configured to project a beam grid of a plurality of charged particle beams along a grid path of the beam grid towards the sample; an optical measurement system configured to measure a topographical map representing a topography of the sample surface; and a control system configured to use the measured topographical map to control a positioning of the sample during processing of the sample by the beam grid, desirably the optical measurement system comprising a light source and an array of sensing elements, desirably arranged in a linear array desirably dimensioned to extend across a maximum dimension of the sample desirably in a sensing direction, desirably the light source and array of sensing elements configured relative to the sample support such that when the sample is moved relative to the linear array in a scanning direction, desirably angled relative to the sensing direction, desirably the optical measurement system processes the sample surface, desirably the entire sample surface, and the apparatus desirably further comprises a detector configured to detect signal charged particles from the sample and provide an output.
Clause 30. An assessment apparatus for assessing a sample using a plurality of charged particle beams, comprising: a sample support configured to support a sample, the sample having a sample surface; a charged particle device configured to project a beam grid of a plurality of charged particle beams along a grid path of the beam grid towards the sample; a plurality of proximity sensors configured to face the sample, each proximity sensor configured to measure a distance between the proximity sensor and the sample and provide output data; and a control system configured to: generate a sample surface topographical map representing a topography of the sample surface by controlling the sample support to move the sample through a range of positions and/or orientations relative to the charged particle device while using the proximity sensors to measure respective changes in distances between the proximity sensors and the sample surface; and use the generated sample surface topographical map to control the position and/or orientation of the sample during processing of the sample by the beam grid, wherein the position and/or orientation of the sample is controlled to move through a continuous range of different positions and/or orientations during the processing.
Clause 31. An assessment apparatus for assessing a sample using a plurality of charged particle beams, comprising: a sample support configured to support a sample, the sample having a sample surface; a charged particle device configured to project a beam grid of a plurality of charged particle beams along a grid path of the beam grid towards the sample; a plurality of proximity sensors configured to face the sample, desirably positioned spaced away from the grid path, each proximity sensor configured to measure a distance between the proximity sensor and the sample; and a control system configured to: generate a sample surface topographical map representing a topography of the sample surface by controlling the sample support to move the sample through a range of sample positions relative to the charged particle device while using the proximity sensors to measure respective changes in distance between the proximity sensors and the sample surface; use the generated sample surface topographical map to control positioning of the sample during processing of the sample by the beam grid; and receive a sample support topographical map representing a topography of the sample support and to use the received sample support topographical map either: to determine a calibrated sample surface topographical map, wherein desirably the using of the generated sample surface topographical map to control positioning of the sample uses the calibrated sample surface topographical map; or to calibrate the generation of the sample surface topographical map, desirably so that the generated sample surface topographical map is calibrated by the sample support topographical map.
Clause 32. The apparatus of clause 31, wherein the control system is configured such that in the calibration of the generation of the sample surface topographical map, a position in the sample support topographical map is fed forward for the determining of a same position in the sample surface topographical map, desirably the control system being configured to control the sample support based on the position in the sample support topographical map to process a respective target position at the same position in the sample surface topographical map.
Clause 33. A method of assessing a sample using a plurality of charged particle beams, comprising: scanning at least a subset of a beam grid of a plurality of charged particle beams and respective target portions of a sample surface relative to each other, so as to process the target portions with the beams; detecting signal charged particles from the sample and generating detection signals on detection of the signal charged particles; and generating a sample surface topographical map representing a topography of the sample surface by analyzing detection signals detected in response to the scanning of the at least a subset of the beam grid and respective target portions relative to each other.
Clause 34. The method of clause 33, wherein controlling the scanning of the at least a subset of the beam grid and respective target portions relative to each other at a plurality of focus condition settings.
Clause 35. The method of clause 34, wherein each focus condition setting defines a relative position between the focal plane and the respective target portion for each charged particle beam of the at least a subset of the beam grid.
Clause 36. The method of clause 34 or 35, wherein the scanning of the at least a subset of the beam grid and respective target portions relative to each other at the plurality of focus condition settings comprises processing by each charged particle beam of the at least a subset of the beam grid of all of the target portion corresponding to that charged particle beam once at each of the plurality of focus condition settings.
Clause 37. The method of any of clauses 34 to 36, wherein controlling the positioning of the sample support in at least one degree of freedom with respect to the charged particle device to implement the plurality of focus condition settings, desirably the at least one degree of freedom comprising: a position of the sample support along the grid path; and/or an orientation of the sample support, desirably tilt relative to a direction orthogonal to the grid path.
Clause 38. The method of any of clauses 34 to 37, wherein controlling the positioning of a focal plane of each charged particle beam of the at least a subset of the beam grid relative to the charged particle device so as to implement the plurality of focus condition settings.
Clause 39. The method of any of clauses 34 to 38, wherein the analyzing of detection signals comprises calculating a metric representing a quality of focus during the processing of each target portion at each focus condition setting.
Clause 40. The method of clause 39, wherein the metric comprises a contrast level in an image of the target portion derived from the detection signals.
Clause 41. The method of any of clauses 34 to 40, further comprising generating the sample surface topographical map by identifying an optimal focus condition setting from the plurality of different focus condition settings for each target portion of the sample surface processed by the scan of the at least a subset of the beam grid and respective target portions of the sample surface relative to each other.
Clause 42. The method of any of clauses 34 to 41, further comprising importing an externally-derived topographical map representing a topography of the sample surface measured using an external device and desirably selecting one or more of the different focus condition settings by using the externally-derived topographical map.
Clause 43. A method of assessing a sample using a plurality of charged particle beams, comprising: importing an externally-derived topographical map representing a topography of a sample surface of a sample measured using an external device; and processing the sample using a beam grid of a plurality of charged particle beams while controlling a positioning of the sample using the externally-derived topographical map and output data from a plurality of proximity sensors measuring distances to the sample from the proximity sensors.
Clause 44. A method of assessing a sample using a plurality of charged particle beams, comprising: receiving a sample support topographical map representing a topography of a surface of a sample support supporting a sample; and processing the sample using a beam grid of a plurality of charged particle beams while controlling a positioning of the sample using the sample support topographical map and output data from a plurality of proximity sensors measuring distances to the sample from the proximity sensors.
Clause 45. A method of assessing a sample using a plurality of charged particle beams, comprising: optically measuring a topographical map representing a topography of a sample surface of a sample; and using the measured topographical map to control a positioning of the sample during processing of the sample by a beam grid of a plurality of charged particle beams.
Clause 46. A method of assessing a sample using a plurality of charged particle beams, comprising: generating a sample surface topographical map representing a topography of a sample surface of a sample by moving the sample through a range of positions and/or orientations while using proximity sensors to measure respective changes in distances between the proximity sensors and the sample surface; and using the generated sample surface topographical map to control the position and/or orientation of the sample during processing of the sample by a beam grid of a plurality of charged particle beams, wherein the position and/or orientation of the sample is controlled to move through a continuous range of different positions and/or orientations during the processing.
Clause 47. A method of assessing a sample using a plurality of charged particle beams, comprising: generating a sample surface topographical map representing a topography of a sample surface of a sample by moving the sample through a range of sample positions while using proximity sensors to measure respective changes in distance between the proximity sensors and the sample surface; using the generated sample surface topographical map to control positioning of the sample during processing of the sample by a beam grid of a plurality of charged particle beams; and receiving a sample support topographical map representing a topography of a sample support supporting the sample and using the received sample support topographical map either: a) to determine a calibrated sample surface topographical map, wherein desirably the using of the generated sample surface topographical map to control positioning of the sample uses the calibrated sample surface topographical map; or b) to calibrate the generation of the sample surface topographical map, desirably so that the generated sample surface topographical map is calibrated by the sample support topographical map.

## Claims

1. An assessment apparatus for assessing a sample using a plurality of charged particle beams, comprising:
a sample support configured to support a sample, the sample having a sample surface;
a charged particle device configured to project a beam grid of a plurality of charged particle beams along a grid path of the beam grid towards the sample;
a detector configured to detect signal charged particles from the sample and generate detection signals on detection of the signal charged particles; and
a control system configured to:
control the sample support, the charged particle device and/or the detector to:
scan at least a subset of the beam grid and respective target portions of the sample surface relative to each other, so as to process the target portions; and
generate a sample surface topographical map representing a topography of the sample surface by analyzing detection signals detected in response to the scan of the at least a subset of the beam grid and respective target portions relative to each other.

2. The apparatus of claim 1, wherein the control system is configured to control the sample support, the charged particle device and/or the detector to perform the scan of the at least a subset of the beam grid and respective target portions relative to each other at a plurality of focus condition settings of the apparatus.

3. The apparatus of claim 2, wherein each focus condition setting defines a relative position between the focal plane and the respective target portion for each charged particle beam of the at least a subset of the beam grid.

4. The apparatus of claim 2 or 3, wherein the scan of the at least a subset of the beam grid and respective target portions relative to each other at the plurality of focus condition settings comprises each charged particle beam of the at least a subset of the beam grid processing all of the target portion corresponding to that charged particle beam once at each of the plurality of focus condition settings.

5. The apparatus of any of claims 2 to 4, wherein the control system is configured to implement the plurality of focus condition settings by controlling the positioning of the sample support in at least one degree of freedom with respect to the charged particle device, desirably the at least one degree of freedom comprising: a position of the sample support along the grid path; and/or an orientation of the sample support, desirably tilt relative to a direction orthogonal to the grid path.

6. The apparatus of any of claims 2 to 5, wherein the control system is configured to implement the plurality of focus condition settings by controlling the positioning of a focal plane of each charged particle beam of the at least a subset of the beam grid relative to the charged particle device.

7. The apparatus of any of claims 2 to 6, wherein the control system is configured such that the analyzing of detection signals comprises calculating a metric representing a quality of focus during the processing of each target portion at each focus condition setting.

8. The apparatus of any of claims 2 to 7, wherein the control system is configured to generate the sample surface topographical map by identifying an optimal focus condition setting from the plurality of different focus condition settings for each target portion of the sample surface processed by the scan of the at least a subset of the beam grid and respective target portions of the sample surface relative to each other.

9. The apparatus of any of claims 2 to 8, wherein the control system is configured to import an externally-derived topographical map representing a topography of the sample surface measured using an external device and to use the externally-derived topographical map to select one or more of the different focus condition settings.

10. The apparatus of any of claims 2 to 9, wherein:
the apparatus comprises an optical measurement system configured to measure a topographical map representing a topography of the sample surface; and
the control system is configured to use the measured topographical map to select one or more of the different focus condition settings.

11. The apparatus of any of claims 2 to 10, wherein the control system is further configured to receive a sample support topographical map representing a topography of the sample support and to use the sample support topographical map to select one or more of the different focus condition settings.

12. The apparatus of any preceding claim, wherein the control system is configured to use the generated sample surface topographical map during a subsequent processing of the sample using at least a portion of the beam grid, to:
control positioning of the sample during the subsequent processing; and/or
control positioning of the focal plane for each of one or more of the charged particle beams of the at least a portion of the beam grid during the subsequent processing.

13. The apparatus of any preceding claim, wherein the charged particle device comprises a plurality of proximity sensors configured to face the sample, each proximity sensor configured to measure a distance between the proximity sensor and the sample, desirably the proximity sensors being capacitive sensors, desirably differential capacitive sensors.

14. The apparatus of claim 13, wherein the control system is configured to use the generated sample surface topographical map and output data from the one or more proximity sensors during a subsequent processing of the sample using at least a portion of the beam grid

15. The apparatus of any preceding claim, wherein the control system is configured to use the generated sample surface topographical map to select a grid path position of the sample along the grid path, and/or wherein the control system is configured to use the generated sample surface topographical map to select a common focal plane.
